# EUROPEAN PATENT APPLICATION

(11) **EP 2 624 543 A2**
(43) Date of publication of application: **07.08.2013**
(21) Application number: 13153935.5
(22) Date of filing: 04.02.2013
(51) Int. Cl.: H04N 5/64, G02F 1/1333

(54) **Display device and manufacturing method**

(30) Priority: 06.02.2012 KR 20120012050
(71) Applicant: Samsung Electronics Co., Ltd., Gyeonggi-do 443-742 (KR)
(72) Inventor: Cho, Chang Ho, Gyeonggi-do (KR); Min, Sung Ki, Gyeonggi-do (KR); Shim, Dong Hee, Gyeonggi-do (KR); Lee, Sang Yoong, Gyeonggi-do (KR); Lee, Jong Won, Seoul (KR)
(74) Representative: Misselbrook, Paul

(57) **Abstract**

A display device and a method of manufacturing the same are provided. The display device includes a display module which displays an image, and a chassis which forms an outer appearance of the display module, the chassis including a background surface, wherein the background surface of the chassis includes a first coating surface forming a base of the background surface of the chassis and a second coating surface provided on a plane different from the first coating surface. The display device and the method for manufacturing the same are thus effective in reducing required space and manufacturing time. In addition, the display device and the method of manufacturing the same do not require a process such as washing. In addition, the display device and the method for manufacturing the same enable coating to be performed in local regions and thus reduce the distribution costs.

## Description

### BACKGROUND

### 1. Field

Embodiments of the inventive concept relate to a display device and a method of manufacturing the same, wherein an improved method of coating a display device is provided.

### 2. Description of the Related Art

In general, a display device is used to display an image. A display device is required to implement televisions and monitors of desktop computers, as well as portable computers such as notebooks, computers and PDAs or small, lightweight systems such as cellular phone terminals.

Useful display devices include flat display panels such as liquid crystal displays (LCDs), plasma display panels (PDPs), field emission displays (FEDs), etc.

In general, such a display device includes a panel module having a top chassis which covers an edge excluding a display region of a flat display panel and a bottom chassis coupled to the top chassis and covering the back of the flat display panel. The display device may accommodate the panel module using a separate cover or case. However, commercially available display device products have a structure in which a top chassis covering an edge of a flat display panel is directly exposed and the top chassis may be coated with black paint.

In one embodiment, to color a top chassis of a display device using electrodeposition coating, in which the top chassis is dipped in paint for electrodeposition, electricity is then applied thereto and a coating film is electrochemically formed on the overall surface. However, in accordance with this method, first, the top chassis are manufactured using an extrusion molding method and respective top chassis are subjected to electrodeposition coating. This results in price increases due to increased manufacturing time and an increased cost of manufacture.

### SUMMARY

Therefore, it is an aspect of the inventive concept to provide a display device and a manufacturing method in which the display device is efficiently coated.

Additional aspects of the inventive concept will be set forth in part in the description which follows and, in part, will be obvious from the description, or may be learned by practice of the inventive concept.

In accordance with one aspect of the inventive concept, a display device includes: a display module which displays an image; and a chassis which forms an outer appearance of the display module, the chassis including a background surface, wherein the background surface of the chassis includes: a first coating surface forming a base of the background surface of the chassis; and a second coating surface provided along a plane different from the first coating surface.

The second coating surface may include a cut surface which is formed through cutting the background surface of the chassis.

The background surface of the chassis may include a steel sheet.

The steel sheet may be a coated steel sheet.

The chassis may include: a top chassis coupled to a front surface of the display module; and a bottom chassis coupled to a back surface of the display module.

The display device may further include a rear cover provided outside the bottom chassis.

In accordance with another aspect of the inventive concept, a method of manufacturing a display device includes: injecting a coated steel sheet forming an outer appearance of the display device; fixing the coated steel sheet using a jig; and coating a cut surface of the coated steel sheet using a coating pad which is made of a flexible material and is stained with paint.

The coating pad may include a pad made of at least one of silicone and urethane.

The method may further include curing the coated steel sheet.

The curing may be carried out using infrared radiation (IR).

The infrared radiation may be middle infrared radiation (MIR).

The jig may include: a support which supports the coated steel sheet at a predetermined height; and a base to prevent inclination or collapse of the coated steel sheet.

The support may include a step at a point where the support contacts the coating pad in order to facilitate a coating operation of the coating pad.

The coating pad may coat the coated steel sheet by repeatedly moving in a vertical direction.

The coating pad may include a plurality of coating pads having identical or different sizes and the coating of the coated steel sheet may be carried out at least one time using the coating pads.

Each coating pad may include: an inclined portion having a decreased width; and a protrusion portion extending from the inclined portion.

An exemplary embodiment may provide a display device including: a chassis including a background surface, wherein the background surface of the chassis comprises: a coating surface which includes a painted cut surface.

An exemplary embodiment may further provide a method of manufacturing a display device, the method including: injecting a coated steel sheet which forms an outer appearance of the display device; and coating a cut surface of the coated steel sheet using a coating pad which is made of a flexible material and is stained with paint. The coating pad may coat the cut surface coated steel sheet by repeated movement of the coating pad. The coating pad may move in a vertical direction.

### BRIEF DESCRIPTION OF THE DRAWINGS

These and/or other aspects of the inventive concept will become apparent and more readily appreciated from the following description of the exemplary embodiments, taken in conjunction with the accompanying drawings of which:
FIG. 1 is a front view illustrating a display device according to an exemplary embodiment;
FIG. 2 is an exploded view illustrating a display device according to an exemplary embodiment of the inventive concept;
FIG. 3 is an enlarged view illustrating a chassis of the display device according to an exemplary embodiment of the inventive concept;
FIG. 4 is a schematic view illustrating a process of coating the display device according to an exemplary embodiment of the inventive concept;
FIG. 5 is a view illustrating a coating pad according to an exemplary embodiment of the inventive concept;
FIG. 6 is a schematic view illustrating a completion of coating in accordance with a method of manufacturing a display device according to an exemplary embodiment of the inventive concept; and
FIG. 7 is a flowchart illustrating a method of manufacturing the display device according to an exemplary embodiment of the inventive concept.

### DETAILED DESCRIPTION

Reference will now be made in detail to exemplary embodiments of the inventive concept, examples of which are illustrated in the accompanying drawings, wherein like reference numerals refer to like elements throughout.

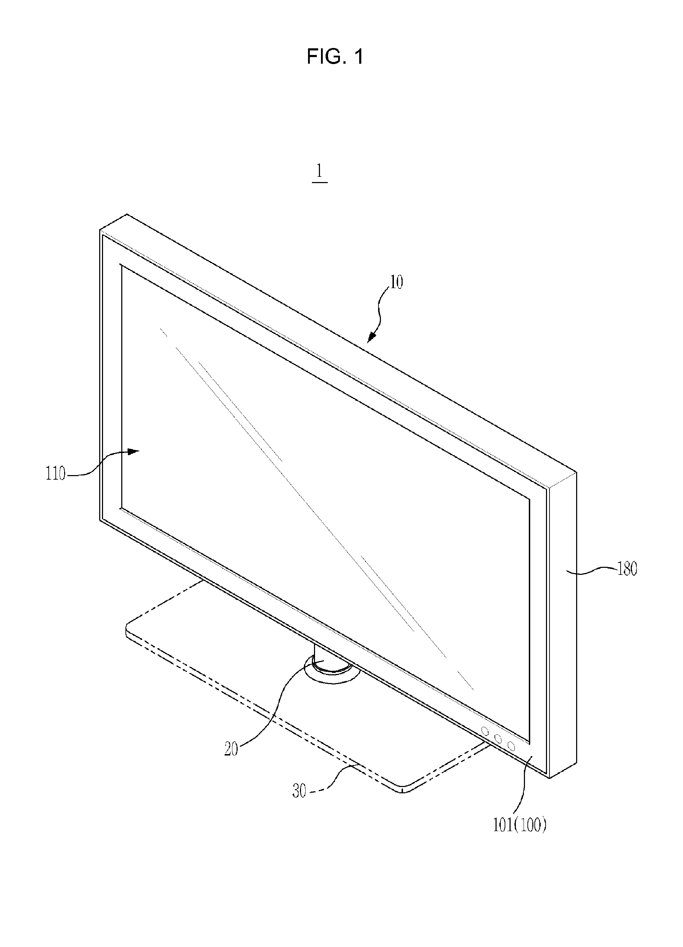

FIG. 1 is a front view illustrating a display device according to an exemplary embodiment.

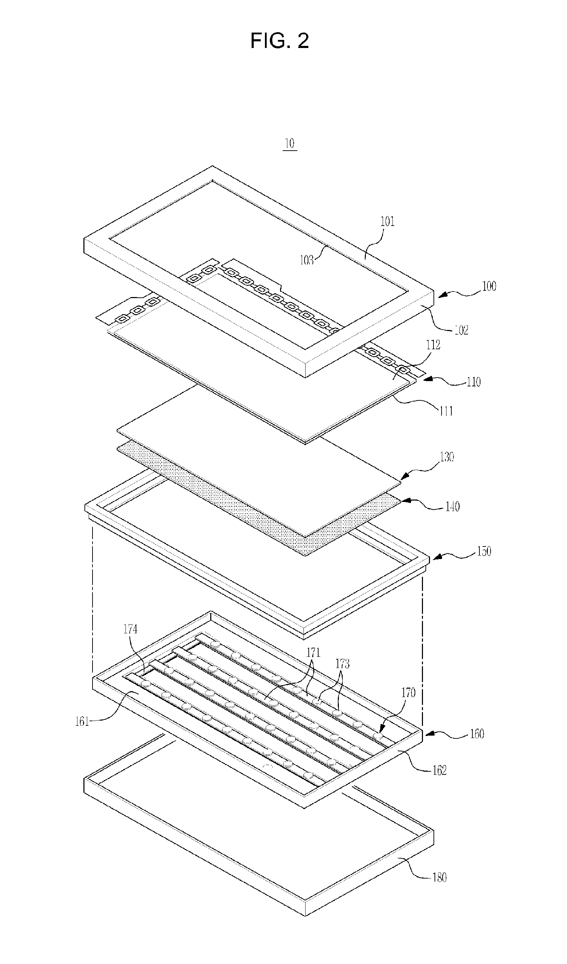

As shown in FIGS. 1 and 2, the display device 1 includes a display module 10 which displays an image, and chassis 100 and 160 which forms the appearance of the display module 10. In an exemplary embodiment, a coated steel sheet is used for chassis 100 and 160. The coated steel sheet is also referred to as pre-coated metal (PCM) which means a steel sheet which is preliminarily coated prior to product manufacture. A cover may be coupled to the outside of the chassis 100 and 160. Although a front cover or a rear cover may be provided on a rear appearance of the display device 1, in one exemplary embodiment of the inventive concept, an example in which the rear cover 180 forms a rear appearance of the display device 1, the top chassis 100 forms a front appearance thereof.. Also, stands supporting the display module 10 include a neck portion 20 and a base portion 30.

FIG. 2 is an exploded view illustrating the display device according to an exemplary embodiment of the inventive concept.

In this exemplary embodiment, a liquid crystal display is illustrated as an example, but exemplary embodiments of the inventive concept are not limited thereto. The display module 10 includes a liquid crystal panel 110, backlight 170 spaced from one another under the liquid crystal panel 110, a middle mold 150 which supports the liquid crystal panel 110 and the backlight 170 such that the liquid crystal panel 110 is spaced from the backlight 170, and a top chassis 100 and a bottom chassis 160 are respectively disposed on and under the liquid crystal panel 110 and the backlight 170.

The liquid crystal panel 110 includes a thin film transistor substrate 111 provided with a thin film transistor, a color filter substrate 112 facing the thin film transistor substrate 111, and a liquid crystal layer (not shown) provided between the thin film transistor substrate 111 and the color filter substrate 112.

The liquid crystal panel 110 may form an image by controlling arrangement of the liquid crystal layer, but autonomously does not emit light and thus requires a supply of light from a backlight 170 which is disposed on the rear surface, in order to display an image.

The backlight 170 includes a printed circuit substrate 171 disposed on the rear surface of the liquid crystal panel 110 and provided with a conductive pattern, a light emitting diode (not shown) disposed on the front surface of the printed circuit substrate 171, and a circular lens 173 mounted on the light emitting diode (not shown) and diffusing light generated in the light emitting diode (not shown).

A plurality of printed circuit substrates 171 are spaced from one another in parallel and a connection substrate 174 to connect ends of the printed circuit substrates 171 is disposed on ends of the printed circuit substrates 171 in order to enable the printed circuit substrates 171 to move in combination with one another.

Optical sheets 130 and 140 are disposed between the liquid crystal panel 110 and the backlight 170 to improve optical properties of light irradiated from the backlight 170 to the liquid crystal panel 110. In one exemplary embodiment of the inventive concept, the optical sheets 130 and 140 include a diffusion sheet 130 which diffuse light irradiated from the backlight 170 and thereby improve the uniformity of brightness, and a light collection sheet 140 which guides light diffused through the diffusion sheet 130 to be incident in a manner which is perpendicular to the liquid crystal panel 110.

The top chassis 100 forms a front appearance of the display device 1. The top chassis 100 includes a bezel portion 101 surrounding an edge of the liquid crystal panel 110 and a top side bent at the end of the bezel portion 101. The bezel portion 101 refers to a width from a peripheral line of the liquid crystal panel 110 to an active area in which an image is actually displayed.

The bottom chassis 160 has a rectangle-like shape and includes a bottom 161, on which the backlight 170 is mounted, and a bottom side 162 that extends upward from a periphery of the bottom 161. The bottom chassis 160 is made of a thermally conductive metal material and dissipates heat from the light emitting diode (not shown).

The rear cover 180 may be provided outside the bottom chassis 160. The rear cover 180 provides a rear appearance of the display device 1.

The top chassis 100 may be coupled to the inside of the bottom chassis 160 or to the outside of the bottom chassis 160. The coupled top chassis 100 and bottom chassis 160 are defined as panel modules. The rear cover 180 is coupled to the outside of the rear surface of the panel module. Accordingly, in one exemplary embodiment of the inventive concept, the top chassis 100 and the rear cover 180 provide the appearance of the display.

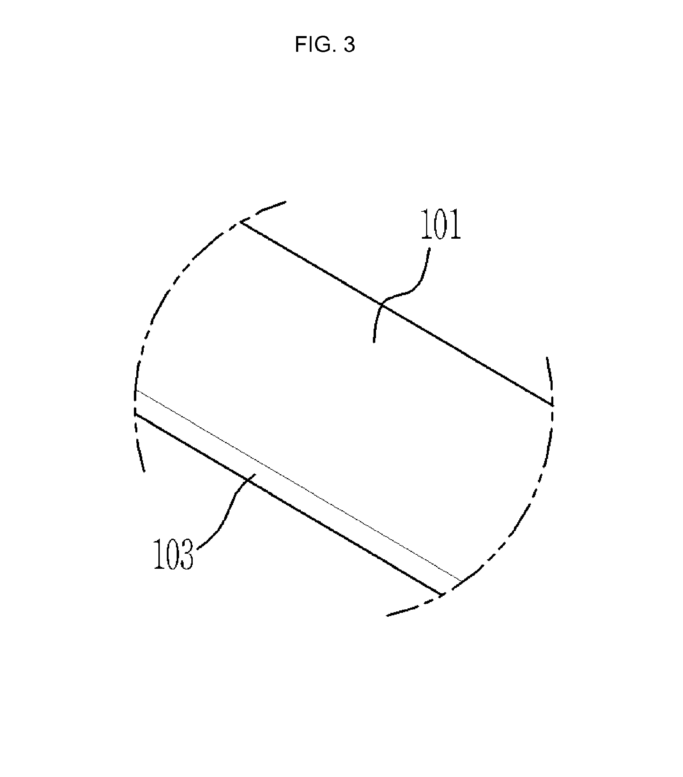

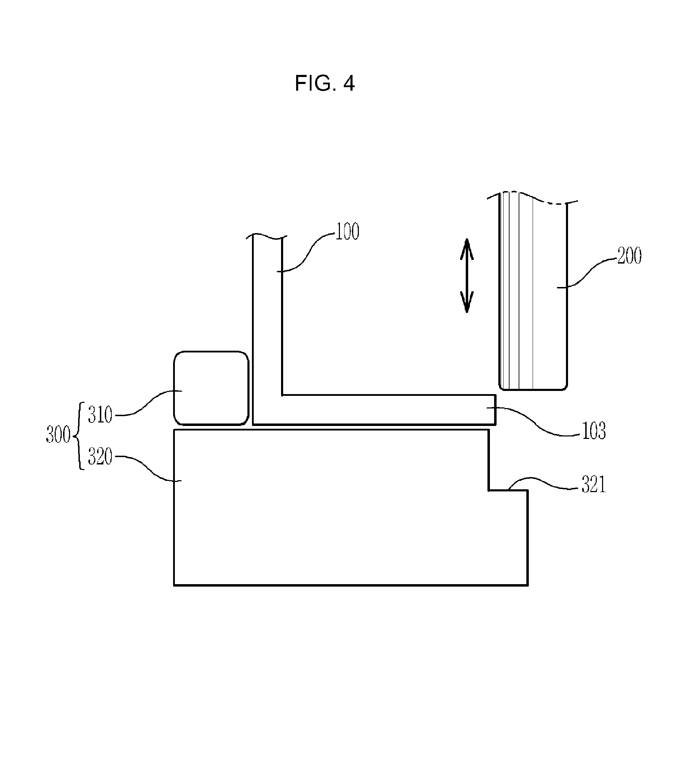

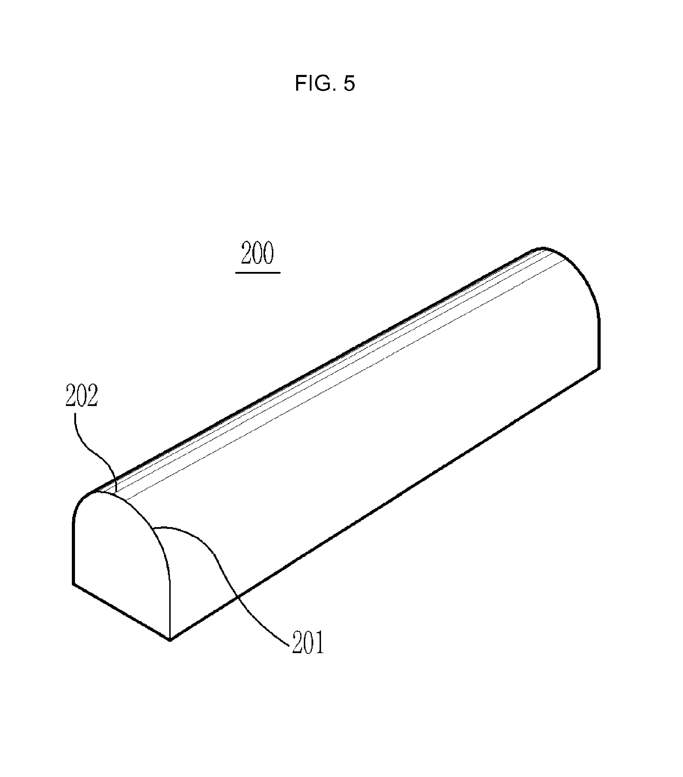

FIG. 3 is an enlarged view illustrating a chassis of the display device according to one exemplary embodiment of the inventive concept. FIG. 4 is a schematic view illustrating a process of coating the display device according to one exemplary embodiment of the inventive concept. FIG. 5 is a view illustrating a coating pad according to one exemplary embodiment of the inventive concept.

Hereinafter, the top chassis will be described as an example, but exemplary embodiments of the inventive concept are not limited thereto. As shown in FIG. 3, the top chassis 100 may include a first coating surface which forms a background surface and a second coating surface provided along a plane which is different from the first coating surface. The second coating surface may be provided on a cut surface 103 formed through cutting the background surface of the top chassis 100. In one exemplary embodiment of the inventive concept, the top chassis 100 may be made of a coated steel sheet. The coated steel sheet does not require much equipment and is eco-friendly, but it is disadvantageously difficult to coat the cut surface. In order to solve this disadvantage, according to the inventive concept, the cut surface 103 is coated using a coating pad 200 made of a soft material. That is, the first coating surfaces of the chassis 100 and 160 according to the inventive concept are coated before manufacture of the chassis 100 and 160, while the second coating surface is coated using a coating pad 200 after manufacture of the chassis 100 and 160.

As shown in FIG. 4, the top chassis 100, which may be formed of a coated steel sheet, may be fixed on a jig 300. The jig 300 includes a support 320 which supports the coated steel sheet to a predetermined height and a base 310 which prevents inclination or collapse of the coated steel sheet. The support 320 includes a step 321 disposed at a point in which the support 320 contacts the coating pad 200 in order to easily coat the cut surface 103 with the coating pad 200. The jig 300 may be made of plastic or aluminum.

When the top chassis 100 is fixed on the jig 300, the cut surface 103 is coated using the coating pad 200. The coating pad 200 is made of a flexible material which coats the cut surface 103 which has a narrow cross-sectional area. For example, the coating pad 200 may include at least one of silicone and urethane.

The coating pad 200, stained with paint, moves vertically to coat the cut surface 103. In the case of black paint, a paint used may be apaint for pad applications such as 788black + 700HDP, 750black + 700GL, but exemplary embodiments of the inventive concept are not limited thereto. A variety of colors of paints may be used depending on the color of the top chassis 100.

As shown in FIG. 5, the coating pad 200 may include an inclined portion 201 having a decreased width and a protrusion portion 202 that extends from the inclined portion 201. Referring to FIG. 5, the inclined portion 201 has a curved surface, but exemplary embodiments of the inventive concept are not limited thereto. The inclined portion 201 may be curved or straight. During coating, the protrusion portion 202 faces the cut surface 103 and the cut surface 103, which has a narrow cross-sectional area, may be efficiently coated.

During coating, the cut surface 103 may be coated using a plurality of coating pads 200 rather than a single coating pad 200. When different sizes of coating pads 200 are used, coating can be more efficiently performed.

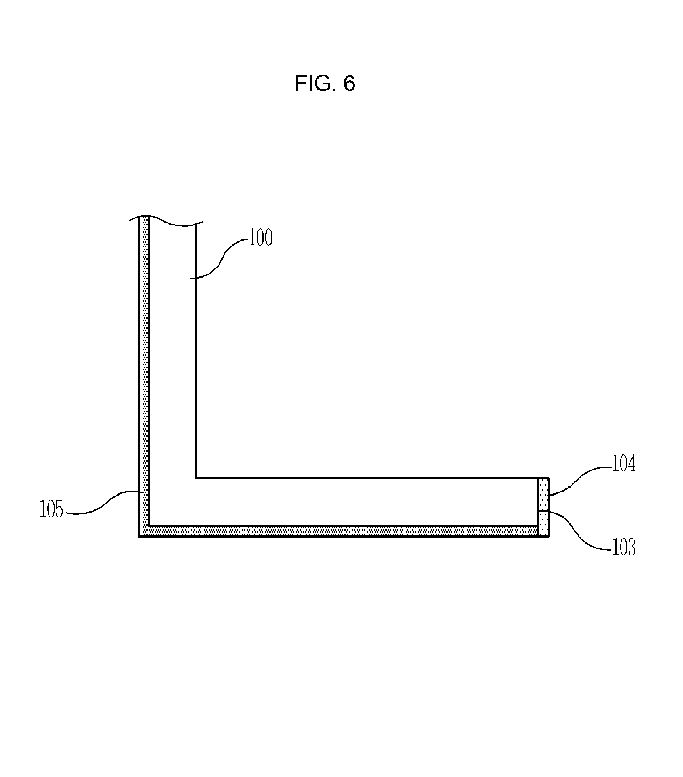

FIG. 6 is a schematic view illustrating the completion of the coating process in accordance with a method for manufacturing the display device according to an exemplary embodiment of the inventive concept.

As shown in FIG. 6, paints of the top chassis 100 with two paints. One is a paint 105 colored in the coated steel sheet which corresponds to the top chassis 100 which is coated on the first coating surface. The other is a paint 104 coated on the cut surface 103 of the top chassis 100 using the coating pad 200, which is coated on the second coating surface.

When the cut surface 103 of the top chassis 100 is coated, regions other than the cut surface 103 may also be colored with paint because the coating pad 200 is used. However, these regions may be formed during the coating process. Separate correction is unnecessary since paints which appear similar are used. According to the exemplary embodiments of the inventive concept, as the chassis 100 and 160 are coated with paint in a two-stage operation, operation of several processes is unnecessary, as compared to conventional electrodeposition coating. In addition, the exemplary embodiment is advantageously eco-friendly since washing is unnecessary.

The top chassis 100 will be described as an example, but the exemplary embodiments of the inventive concept are not limited thereto. The exemplary embodiments of the inventive concept may be used for selectively coating the cut surface of the display device.

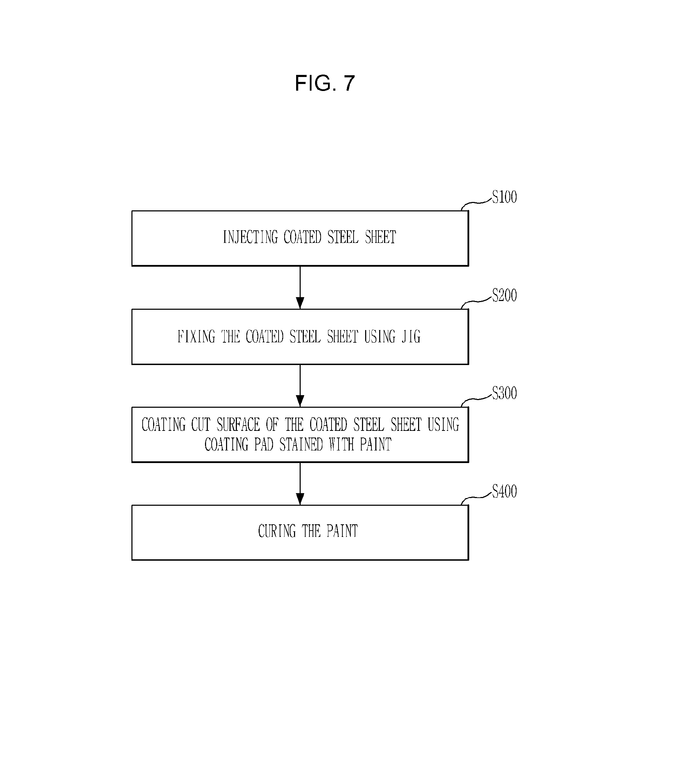

FIG. 7 is a flowchart which illustrates a method of manufacturing a display device according to an exemplary embodiment of the inventive concept.

As shown in FIG. 7, the method of manufacturing the display device according to an exemplary embodiment includes injecting a coated steel sheet (S100); fixing the coated steel sheet using a jig (S200); coating a cut surface of the coated steel sheet using a coating pad stained with paint (S300), and curing the paint (S400).

After injection of the coated steel sheet 100 (S100), the coated steel sheet 100 is fixed to the jig 300 (S200). The jig 300 may include a support 320 which supports the coated steel sheet 100 at a predetermined height and a base 310 which prevents inclination or collapse of the coated steel sheet 100. The base 310 functions to support the coated steel sheet in a direction opposite to a coating direction. The jig 300 enables the coated steel sheet 100 to be stably fixed during coating using the coating pad 200.

Coating of the cut surface 103 of the coated steel sheet 100 using the coating pad 200 (S300) is carried out by coating the cut surface 103 having a cross-sectional area using the coating pad 200 which is made of a flexible material. The coating pad 200 made of a flexible material is for example a pad made of at least one of silicone and urethane. In addition, the coating pad 200 may include a protrusion portion 202 having a protruded center in order to perfectly and thoroughly coat the cut surface 103 with paint. The protrusion portion 202 may be connected to the inclined portion 201. That is, the coating pad 200 has a gradually decreased width at the inclined portion 201 and extends to the protrusion portion 202.

During coating (S300), the coating pad 200 repeatedly moves in a vertical direction to coat the coated steel sheet 100. In addition, during coating of the coated steel sheet 100, only one coating pad 200 may be used and coating may be performed in several stages using the same or different sizes of coating pads 200.

During curing of the coating (S400), the coating colored with the coating pad 200 during coating (S300) is cured. The curing may be carried out using infrared radiation (IR). Infrared radiation has a wavelength range of about 750 nm to about 1 mm. In particular, curing may be carried out using middle infrared radiation and middle infrared ray has a wavelength range of about 2,500 nm to 25,000 nm.

According to one exemplary embodiment of the inventive concept, the process is eco-friendly since chemical treatment is unnecessary, and efficiency may be increased since the overall process is simple. Also, equipment for electrodeposition coating is unnecessary due to use of the coated steel sheet and inexpensive production is possible by locally supplying components. Accordingly, distribution costs are advantageously reduced due to there being no necessity of supplying components from abroad.

As is apparent from the above description, the display device and the method for manufacturing the same according to exemplary embodiments of the inventive concept do not require complicated equipment and space and are thus effective in reducing required space and manufacturing time.

The display device and the method of manufacturing the same do not require a process such as washing, and thus enable development of eco-friendly products due to a minimal release of contaminants.

In addition, the display device and the method of manufacturing the same enable coating to be performed in local regions and thus reducing distribution costs.

Although a few exemplary embodiments of the inventive concept have been shown and described, it would be appreciated by those skilled in the art that changes may be made in these exemplary embodiments without departing from the principles and spirit of the invention, the scope of which is defined in the claims and their equivalents.

## Claims

1. A display device comprising:
a display module to display an image; and
a chassis to form an outer appearance of the display module, the chassis comprising a background surface,
wherein the background surface of the chassis comprises:
a first coating surface forming a base of the background surface of the chassis; and
a second coating surface provided on a plane different from the first coating surface.

2. The display device according to claim 1, wherein the second coating surface comprises a cut surface formed through cutting the background surface of the chassis.

3. The display device according to claim 1, wherein the background surface of the chassis comprises a steel sheet.

4. The display device according to claim 3, wherein the steel sheet is a coated steel sheet.

5. The display device according to claim 1, wherein the chassis comprises:
a top chassis coupled to a front surface of the display module; and
a bottom chassis coupled to a back surface of the display module.

6. The display device according to claim 5, further comprising: a rear cover provided outside the bottom chassis.

7. A method of manufacturing a display device, the method comprising:
injecting a coated steel sheet forming an outer appearance of the display device;
fixing the coated steel sheet in place using a jig; and
coating a cut surface of the coated steel sheet using a coating pad made of a flexible material and stained with paint.

8. The method according to claim 7, wherein the coating pad comprises a pad made of at least one of silicone and urethane.

9. The method according to claim 7, further comprising: curing the coated steel sheet.

10. The method according to claim 8, wherein the curing is carried out using infrared radiation (IR).

11. The method according to claim 10, wherein the infrared radiation is middle infrared radiation (MIR).

12. The method according to claim 7, wherein the jig comprises:
a support to support the coated steel sheet at a predetermined height; and
a base to prevent inclination or collapse of the coated steel sheet.

13. The method according to claim 12, wherein the support comprises a step at a point where the support contacts the coating pad in order to facilitate a coating operation of the coating pad.

14. The method according to claim 7, wherein the coating pad coats the coated steel sheet by repeatedly moving in a vertical direction.

15. The method according to claim 8, wherein each coating pad comprises:
an inclined portion having a decreased width; and
a protrusion portion extending from the inclined portion.
